# EUROPEAN PATENT SPECIFICATION

(11) **EP 3 331 036 B1**
(45) Date of publication and mention of the grant of the patent: **28.08.2019**
(21) Application number: 16829985.7
(22) Date of filing: 01.06.2016
(51) Int. Cl.: H01L 35/30, H02N 11/00

(54) **THERMOELECTRIC DEVICE AND THERMOELECTRIC CONVERSION UNIT**
THERMOELEKTRISCHE VORRICHTUNG UND THERMOELEKTRISCHE UMWANDLUNGSEINHEIT
DISPOSITIF THERMOÉLECTRIQUE ET UNITÉ DE CONVERSION THERMOÉLECTRIQUE

(30) Priority: 28.07.2015 JP 2015148186
(43) Date of publication of application: 06.06.2018
(73) Proprietor: Panasonic Intellectual Property Management Co., Ltd., Osaka-shi, Osaka 540-6207 (JP)
(72) Inventor: MITSUYASU, Toshio, Osaka-shi, Osaka 540-6207 (JP); MIYAMOTO, Yutaka, Osaka-shi, Osaka 540-6207 (JP); NAKAMURA, Shinji, Osaka-shi, Osaka 540-6207 (JP); YUKAWA, Noriaki, Osaka-shi, Osaka 540-6207 (JP); KANOU, Hisashi, Osaka-shi, Osaka 540-6207 (JP)
(74) Representative: Vigand, Philippe
(86) International application number: PCT/JP2016/002647
(87) International publication number: WO 2017/017876

(56) References cited:
- WO-A1-2010/090350
- JP-A- H10 144 968
- JP-A- 2003 174 203
- JP-A- 2006 049 872

## Description

### TECHNICAL FIELD

The present invention relates to a thermoelectric device and a thermoelectric conversion unit having a thermoelectric element.

### BACKGROUND ART

As thermoelectric devices or thermoelectric conversion units of this type, electric power generators having thermoelectric elements and heat exchangers having thermoelectric elements have been known, for example. PTL 1 discloses an electric power generator having thermoelectric elements, for example. PTL 2 discloses a heat exchanger having thermoelectric elements

JP10144968 A discloses a further thermoelectric converter.

### Citation List

### Patent Literature

PTL 1: Unexamined Japanese Patent Publication No. 2013-211471
PTL 2: Japanese Unexamined Utility Model Application Publication No. H01-60159

### SUMMARY OF THE INVENTION

At the time of regular maintenance or failure, the electric power generator or the heat exchanger needs to be disassembled before receiving services such as repair or replacement of a component or internal cleaning. Unfortunately, disassembling of these devices is not simple and can thus result in damage to an internal thermoelectric element.

It is an object of the present invention to provide a thermoelectric device and a thermoelectric conversion unit that prevent damage to thermoelectric elements at the time of disassembling work.

To accomplish the object described above, a thermoelectric device according to an aspect of the present invention is given by claim 1 and includes a thermoelectric converter, a first heat conductor, a second heat conductor, a first gap filler, and a first sheet material. The thermoelectric converter has a thermoelectric element built-in. The first and the second heat conductors face each other through the thermoelectric converter. The first gap filler is disposed between the thermoelectric converter and the first heat conductor. The first gap filler is formed of thermal conductive grease. The first sheet material is disposed between the first heat conductor and the first gap filler and/or between the thermoelectric converter and the first gap filler. The first sheet material has flexibility. A surface of the first sheet material opposite from the first gap filler is an anti-adhesive surface having lower adhesiveness than the first gap filler.

A thermoelectric conversion unit according to an aspect of the present invention is given by claim 12 and is disposed between a first heat conductor and a second heat conductor. The thermoelectric conversion unit includes a thermoelectric converter, a first gap filler, and a first sheet material. The thermoelectric converter has a thermoelectric element built-in. The first gap filler is disposed between the thermoelectric converter and the first heat conductor. The first gap filler is formed of thermal conductive grease. The first sheet material is disposed between the first heat conductor and the first gap filler and/or between the thermoelectric converter and the first gap filler. The first sheet material has flexibility. A surface of the first sheet material opposite from the first gap filler is an anti-adhesive surface having lower adhesiveness than the first gap filler.

A thermoelectric device and a thermoelectric conversion unit according to the present invention have the respective configurations described above and thus prevent damage to thermoelectric elements at the time of disassembling work.

### BRIEF DESCRIPTION OF DRAWINGS

FIG. 1 is a cross-sectional view of a thermoelectric device according to a first exemplary embodiment of the present invention.
FIG. 2 is a cross-sectional view of a thermoelectric device according to a variation of the first exemplary embodiment of the present invention.
FIG. 3 is a cross-sectional view of a thermoelectric device according to another variation of the first exemplary embodiment of the present invention.
FIG. 4 is a cross-sectional view of a thermoelectric device according to another variation of the first exemplary embodiment of the present invention.
FIG. 5 is a cross-sectional view of a thermoelectric device according to another variation of the first exemplary embodiment of the present invention.
FIG. 6 is a cross-sectional view of a thermoelectric device according to another variation of the first exemplary embodiment of the present invention.
FIG. 7A is a cross-sectional view illustrating a component of a thermoelectric device according to a second exemplary embodiment of the present invention.
FIG. 7B is an elevation view illustrating the component of the thermoelectric device according to the second exemplary embodiment of the present invention.
FIG. 8 is a cross-sectional view of the thermoelectric device according to the second exemplary embodiment of the present invention.
FIG. 9 is an external perspective view of a thermoelectric converter.
FIG. 10 is an internal perspective view of the thermoelectric converter.

### DESCRIPTION OF EMBODIMENTS

Hereinafter, preferable exemplary embodiments of the present invention will be described with reference to the drawings. In the exemplary embodiments described below, same reference numerals are attached to the same structural elements, and redundant description thereof will be omitted.

### FIRST EXEMPLARY EMBODIMENT

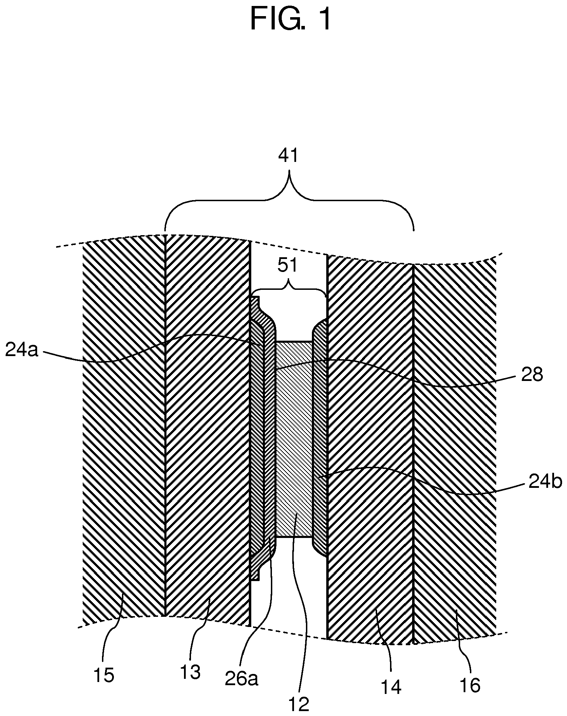

FIG. 1 is a cross-sectional view of thermoelectric device 41 according to a first exemplary embodiment of the present invention. Thermoelectric device 41 includes thermoelectric converter 12, first heat conductor 13, and second heat conductor 14.

First and second heat conductors 13 and 14 face each other through thermoelectric converter 12. First heat conductor 13 is contiguous to first medium 15, whereas second heat conductor 14 is contiguous to second medium 16. One of first and second mediums 15 and 16 is a high-temperature medium. The other of the two mediums is a low-temperature medium. The high-temperature medium is higher in temperature than the low-temperature medium. Examples of the high-temperature medium include steam, oil, exhaust fumes, and molten metals. The high-temperature medium may be a component that receives heat from another heat source. The low-temperature medium is lower in temperature than the high-temperature medium. Examples of the low-temperature medium include cooling water, oil, and air. The low-temperature medium may be a component that gives off heat to another low-temperature medium.

First heat conductor 13 may be, for example, a duct through which first medium 15 passes, or may be a component that is combined with first medium 15 such that the two members can exchange heat with each other. Second heat conductor 14 may be, for example, a duct through which second medium 16 passes, or may be a component that is combined with second medium 16 such that the two members can exchange heat with each other. First and second heat conductors 13 and 14 may be structures made from metals such as aluminum and stainless steel, resin-made structures, or films, for example.

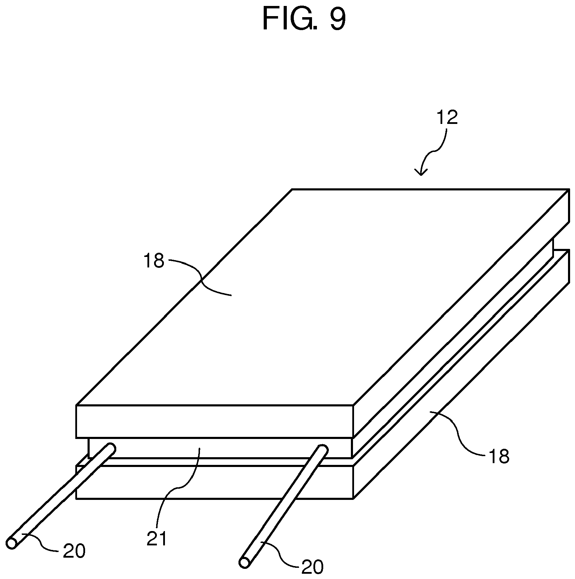

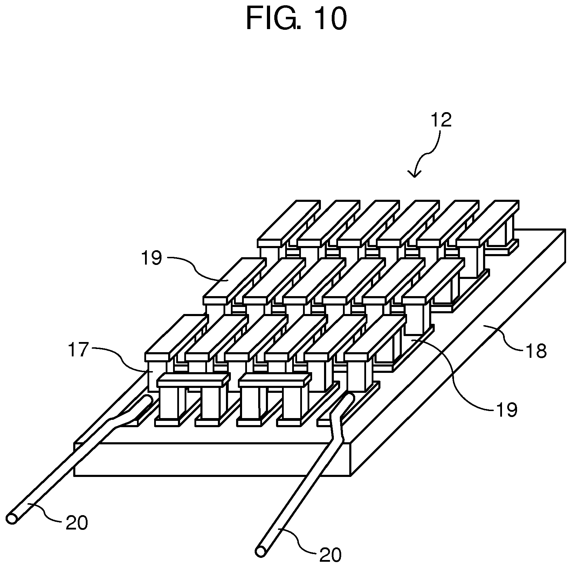

Thermoelectric converter 12 is also referred to as a thermoelectric conversion module and has thermoelectric elements 17 built-in (refer to FIG. 10). An example of thermoelectric converter 12 is shown in FIGS. 9 and 10.

FIG. 9 is an external perspective view of thermoelectric converter 12. FIG. 10 is an internal perspective view of thermoelectric converter 12. In FIGS. 9 and 10, thermoelectric converter 12 has a plurality of thermoelectric elements 17 between a pair of substrates 18. Thermoelectric elements 17 are electrically connected with one another via a plurality of electrodes 19 that are formed on surfaces of the pair of substrates 18. Thermoelectric elements 17 are electrically connected with a pair of leads 20 for input and output of electricity. Thermoelectric elements 17 and electrodes 19 are encapsulated between the pair of substrates 18 by sealant 21. Thermoelectric converter 12 of FIG. 10 is equivalent to thermoelectric converter 12 of FIG. 9 without upper substrate 18 and sealant 21. Examples of thermoelectric elements 17 include n-type semiconductors and p-type semiconductors. Thermoelectric converter 12 can generate electric power using thermo electromotive force produced in thermoelectric elements 17 by a temperature difference between the pair of substrates 18 and output electric power to the pair of leads 20. Alternatively, thermoelectric converter 12 can exchange heat between the pair of substrates 18 by supplying electric power to the pair of leads 20 so as to facilitate absorption of heat from one of substrates 18 and dissipation of heat from the other of substrates 18. Thermoelectric converter 12 may have any of a variety of known configurations other than the example configuration shown in FIGS. 9 and 10.

At the time of regular maintenance or failure, thermoelectric device 41 (refer to FIG. 1) requires services such as repair or replacement of thermoelectric converter 12 and other components or internal cleaning. Thus, thermoelectric device 41 is configured such that at least thermoelectric converter 12 and first heat conductor 13 are separable from each other. In other words, if thermoelectric device 41 is disassembled, thermoelectric device 41 may be disassembled into separate thermoelectric converter 12, first heat conductor 13, and second heat conductor 14, for example. Alternatively, thermoelectric device 41 may be disassembled into thermoelectric converter 12 combined with second heat conductor 14 and separate first heat conductor 13. First and second heat conductors 13 and 14 are each assembled using fasteners such as bolts (not illustrated) and nuts (not illustrated), for example.

Thermoelectric device 41 further includes first gap filler 24a and first sheet material 26a having flexibility to reduce loss of heat transmission between first heat conductor 13 and thermoelectric converter 12, ensure efficiency in power generation or heat exchange, and prevent damage to thermoelectric elements 17. In thermoelectric device 41, first gap filler 24a is disposed between thermoelectric converter 12 and first heat conductor 13, while first sheet material 26a is disposed between thermoelectric converter 12 and first gap filler 24a. Thermoelectric device 41 has second gap filler 24b. Second gap filler 24b is disposed between thermoelectric converter 12 and second heat conductor 14. In thermoelectric device 41, a demountable unit having a thermoelectric conversion function is thermoelectric conversion unit 51. Thermoelectric conversion unit 51 includes thermoelectric converter 12, first gap filler 24a, first sheet material 26a, and second gap filler 24b. At the time of a failure in thermoelectric converter 12, thermoelectric conversion unit 51 is removed from thermoelectric device 41 and replaced or repaired. If the thermoelectric conversion function is unnecessary, thermoelectric conversion unit 51 is removed from thermoelectric device 41. In thermoelectric device 41, thermoelectric conversion unit 51 is put between first and second heat conductors 13 and 14 that are fastened to each other by a predetermined force.

First and second gap fillers 24a and 24b fill microscopic asperities on the surfaces of components such as first and second heat conductors 13 and 14 and thermoelectric converter 12, as well as tiny gaps between first heat conductor 13 and thermoelectric converter 12 and between second heat conductor 14 and thermoelectric converter 12. This configuration allows first and second gap fillers 24a and 24b to improve the quality of heat transmission between first and second heat conductors 13 and 14. First and second gap fillers 24a and 24b have surfaces that are adaptable to microscopic surface asperities and gaps. In thermoelectric device 41, first and second gap fillers 24a and 24b are thermal conductive grease. Thermal conductive grease is also referred to as thermal grease and is generally made from a relatively high viscous fluid or gel material. Thermal conductive grease often has a fluid or gelatinous modified silicone resin as a base and often contains dispersed pieces of a metal or a metallic oxide that possess high thermal conductivity. The thermal conductive grease for the gap fillers may be semisolid, adhesive, or gluey other than fluid or gelatinous. Second gap fillers 24b may be any substance such as grease, adhesive agents, gluing agents, and resin sheets that have satisfactory thermal conductivity, other than thermal conductive grease.

First sheet material 26a is a sheet having flexibility and is aluminum foil, copper foil, or other metallic foil, or a resin-made sheet, for example. First sheet material 26a has a thickness ranging from 1 µm to 500 µm inclusive, for example. First sheet material 26a is flexible and is thus adaptable to microscopic asperities on surfaces that the sheet material comes into intimate contact with and tiny gaps. This provides a reduction in heat transmission loss. A surface of first sheet material 26a opposite from first gap filler 24a is anti-adhesive surface 28 having lower adhesiveness than first gap filler 24a. In thermoelectric device 41, anti-adhesive surface 28 of first sheet material 26a is in contact with thermoelectric converter 12. This configuration reduces stress applied to thermoelectric converter 12 at the time of disassembling thermoelectric device 41 into first heat conductor 13 and thermoelectric converter 12. Thus, thermoelectric device 41 prevents damage to thermoelectric elements 17. Anti-adhesive surface 28 of first sheet material 26a decreases adsorption between thermoelectric converter 12 and first heat conductor 13. This configuration facilitates disassembling work on thermoelectric device 41 and thereby improves efficiency in replacement or repair of thermoelectric converter 12. A surface of first sheet material 26a opposite from anti-adhesive surface 28 is contiguous to first gap filler 24a such that first heat conductor 13 and first sheet material 26a hermetically seal first gap filler 24a. In other words, first gap filler 24a is hermetically sealed by first sheet material 26a.

As described above, thermoelectric device 41 includes thermoelectric converter 12, first and second heat conductors 13 and 14, first gap filler 24a, and first sheet material 26a. Thermoelectric converter 12 has thermoelectric elements 17 built-in. First and second heat conductors 13 and 14 face each other through thermoelectric converter 12. First gap filler 24a is disposed between thermoelectric converter 12 and first heat conductor 13. First sheet material 26a disposed between thermoelectric converter 12 and first gap filler 24a has flexibility. A surface of first sheet material 26a opposite from first gap filler 24a is anti-adhesive surface 28 having lower adhesiveness than first gap filler 24a.

Thermoelectric conversion unit 51 disposed between first and second heat conductors 13 and 14 includes thermoelectric converter 12, first gap filler 24a, and first sheet material 26a. Thermoelectric converter 12 has thermoelectric elements 17 built-in. First gap filler 24a is disposed between thermoelectric converter 12 and first heat conductor 13. First sheet material 26a disposed between thermoelectric converter 12 and first gap filler 24a has flexibility. A surface of first sheet material 26a opposite from first gap filler 24a is anti-adhesive surface 28 having lower adhesiveness than first gap filler 24a.

Thermoelectric device 41 and thermoelectric conversion unit 51 having the configuration described above can reduce loss of heat transmission between thermoelectric converter 12 and first heat conductor 13. Thermoelectric device 41 and thermoelectric conversion unit 51 prevent damage to internal thermoelectric elements 17 at the time of being disassembled into thermoelectric converter 12 and first heat conductor 13. In other words, if thermoelectric device 41 is not provided with first sheet material 26a having anti-adhesive surface 28, the adhesiveness of first gap filler 24a results in maintained airtightness between thermoelectric converter 12 and first heat conductor 13. Thus, adsorption between thermoelectric converter 12 and first heat conductor 13 makes it difficult to slide or pull thermoelectric converter 12 off first heat conductor 13. Since thermoelectric device 41 is provided with first sheet material 26a having anti-adhesive surface 28, air readily flows in a gap between anti-adhesive surface 28 and thermoelectric converter 12 at the time of pulling thermoelectric converter 12 off first heat conductor 13. This configuration allows thermoelectric device 41 to be disassembled without application of excessive stress to thermoelectric converter 12 and thus prevents damage to internal thermoelectric elements 17.

Thermoelectric device 41 and thermoelectric conversion unit 51 are often used in environments where temperature difference between first and second heat conductors 13 and 14 is large. As a result, thermoelectric device 41 and thermoelectric conversion unit 51 often undergo distortion and stress inside due to a difference in coefficient of thermal expansion between the components at the time of operation or before and after operation. In thermoelectric device 41 and thermoelectric conversion unit 51, anti-adhesive surface 28 of first sheet material 26a is in contact with thermoelectric converter 12. This configuration can reduce stress applied to thermoelectric converter 12. Accordingly, thermoelectric device 41 and thermoelectric conversion unit 51 also prevent damage to thermoelectric elements 17 during operation or before and after operation of thermoelectric device 41.

Anti-adhesive surface 28 of first sheet material 26a has lower adhesiveness than first gap filler 24a. In other words, anti-adhesive surface 28 may have adhesiveness that is too weak to offset the decrease in adsorption onto thermoelectric converter 12 at the time of disassembling work. It is not that anti-adhesive surface 28 has no adhesive nor adsorptive property. For example, if a minute quantity of machine oil or water is attached to anti-adhesive surface 28 of first sheet material 26a, anti-adhesive surface 28 can have lower adhesiveness than first gap filler 24a. However, since this adhesiveness produces negligible effect on disassembling work, thermoelectric device 41 prevents damage to thermoelectric elements 17.

Thermoelectric device 41 and thermoelectric conversion unit 51 that contain thermal conductive grease as first gap filler 24a provide improved efficiency in heat transmission between first heat conductor 13 and thermoelectric converter 12.

Thermoelectric device 41 and thermoelectric conversion unit 51 that contain metallic foil as first sheet material 26a provide improved efficiency in heat transmission between first heat conductor 13 and thermoelectric converter 12. Thermoelectric device 41 and thermoelectric conversion unit 51 can readily have anti-adhesive surface 28 formed on the metallic foil.

Thermoelectric device 41 and thermoelectric conversion unit 51 are configured such that at least thermoelectric converter 12 and first heat conductor 13 are separable from each other. As a result, thermoelectric converter 12 can be readily repaired or replaced. Thermoelectric device 41 and thermoelectric conversion unit 51 allow undemanding replenishment and replacement of first and second gap fillers 24a and 24b. This configuration facilitates proper maintenance of the performance of thermoelectric device 41.

In thermoelectric device 41 and thermoelectric conversion unit 51, anti-adhesive surface 28 of first sheet material 26a is in contact with thermoelectric converter 12. This inhibits adhesion of first gap filler 24a to thermoelectric converter 12. As a result, thermoelectric converter 12 can be readily and efficiently repaired or replaced. This configuration reduces the occurrence of a stain on thermoelectric converter 12 owing to the adhesion of first gap filler 24a.

In thermoelectric device 41 and thermoelectric conversion unit 51, first gap filler 24a is hermetically sealed by first heat conductor 13 and first sheet material 26a. This configuration prevents leakage and deterioration of first gap filler 24a. This in turn reduces the quantity of replenishment of and the frequency of replacement of first gap filler 24a, resulting in cost-effective thermoelectric device 41 and thermoelectric conversion unit 51.

Thermoelectric device 41 and thermoelectric conversion unit 51 described above act as an electric power generator or a heat exchanger.

When thermoelectric device 41 and thermoelectric conversion unit 51 act as an electric power generator, the electric power generator generates electric power using thermo electromotive force produced in thermoelectric elements 17 by a temperature difference between the heat conductor (one of first and second heat conductors 13 and 14) contiguous to a high-temperature medium and the heat conductor (the other of first and second heat conductors 13 and 14) contiguous to a low-temperature medium. Thermoelectric device 41 and thermoelectric conversion unit 51 act as an electric power generator by making use of a temperature difference between first and second heat conductors 13 and 14. This configuration achieves an electric power generator that prevents damage to thermoelectric elements 17.

When thermoelectric device 41 and thermoelectric conversion unit 51 act as a heat exchanger, the heat exchanger lets electric power supplied to thermoelectric converter 12 and promotes or reduces heat transmission from first heat conductor 13 to second heat conductor 14 or from second heat conductor 14 to first heat conductor 13 in response to the direction of electric current flowing in thermoelectric elements 17. Thermoelectric device 41 and thermoelectric conversion unit 51 act as a heat exchanger that promotes or reduces heat transmission from one of first and second heat conductors 13 and 14 to the other by letting electric power supplied to thermoelectric converter 12. This configuration achieves a heat exchanger that prevents damage to thermoelectric elements 17.

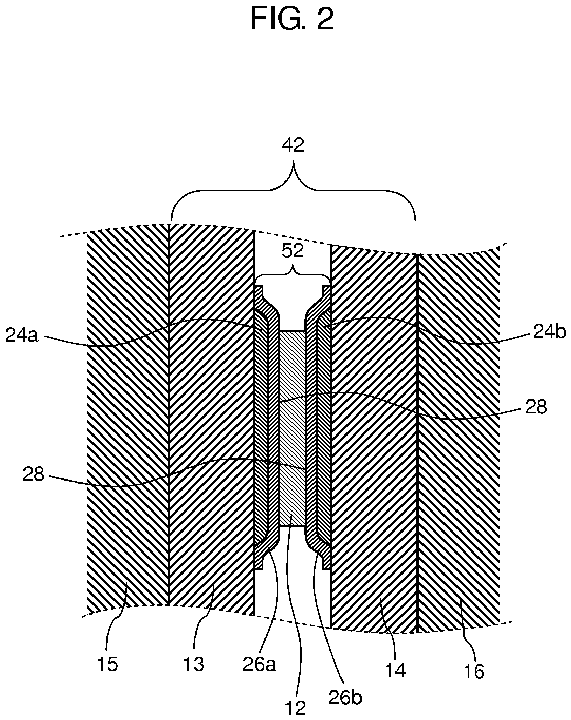

FIG. 2 is a cross-sectional view of thermoelectric device 42 according to a variation of the first exemplary embodiment of the present invention. Thermoelectric device 42 shown in FIG. 2 is equivalent to thermoelectric device 41 of FIG. 1 that further includes second sheet material 26b having flexibility. Second sheet material 26b is disposed between thermoelectric converter 12 and second gap filler 24b. In thermoelectric device 42, thermoelectric conversion unit 52 includes thermoelectric converter 12, first gap filler 24a, second gap filler 24b, first sheet material 26a, and second sheet material 26b. In common with first sheet material 26a, second sheet material 26b is a sheet having flexibility and is aluminum foil, copper foil, or other metallic foil, or a resin-made sheet, for example. A surface of second sheet material 26b opposite from second gap filler 24b is anti-adhesive surface 28 having lower adhesiveness than second gap filler 24b. In thermoelectric device 42, anti-adhesive surface 28 of second sheet material 26b is in contact with thermoelectric converter 12. A surface of second sheet material 26b opposite from anti-adhesive surface 28 is contiguous to second gap filler 24b such that second heat conductor 14 and second sheet material 26b hermetically seal second gap filler 24b. Thermoelectric device 42 is configured such that thermoelectric converter 12 and second heat conductor 14 are separable from each other.

Thermoelectric device 42 and thermoelectric conversion unit 52 shown in FIG. 2 include second gap filler 24b and additional second sheet material 26b. Second gap filler 24b is disposed between thermoelectric converter 12 and second heat conductor 14. Second sheet material 26b disposed between thermoelectric converter 12 and second gap filler 24b has flexibility. A surface of second sheet material 26b opposite from second gap filler 24b is anti-adhesive surface 28 having lower adhesiveness than second gap filler 24b.

This configuration allows thermoelectric device 42 and thermoelectric conversion unit 52 to reduce loss of heat transmission between thermoelectric converter 12 and second heat conductor 14. Thermoelectric device 42 and thermoelectric conversion unit 52 prevent damage to internal thermoelectric elements 17 at the time of being disassembled into thermoelectric converter 12 and second heat conductor 14.

In thermoelectric device 42 and thermoelectric conversion unit 52, anti-adhesive surface 28 of first sheet material 26a and anti-adhesive surface 28 of second sheet material 26b are in contact with respective surfaces of thermoelectric converter 12. This inhibits adhesion of first and second gap fillers 24a and 24b to thermoelectric converter 12. As a result, thermoelectric converter 12 can be readily and efficiently repaired or replaced.

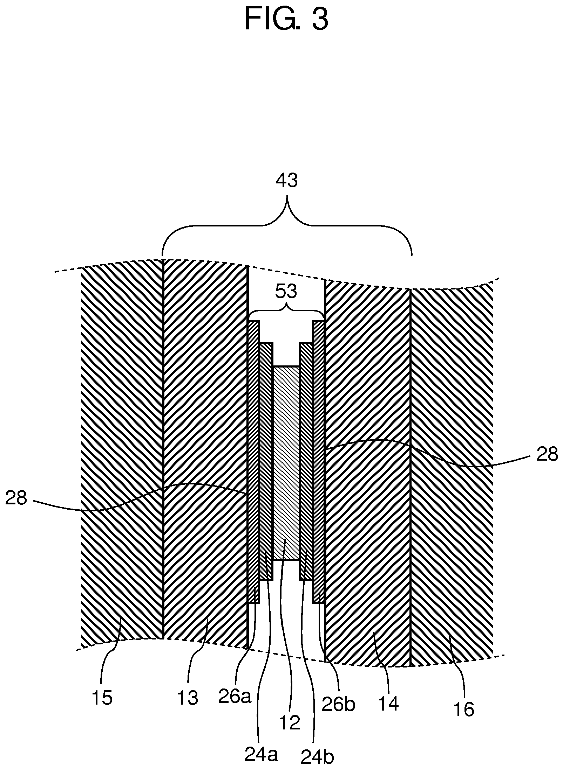

FIG. 3 is a cross-sectional view of thermoelectric device 43 according to another variation of the first exemplary embodiment of the present invention. Thermoelectric device 43 shown in FIG. 3 has a different disposition of first and second sheet materials 26a and 26b as compared with thermoelectric device 42 of FIG. 2. In other words, first sheet material 26a is disposed between first heat conductor 13 and first gap filler 24a. A surface of first sheet material 26a opposite from first gap filler 24a is anti-adhesive surface 28 having lower adhesiveness than the first gap filler. Second sheet material 26b is disposed between second heat conductor 14 and second gap filler 24b. A surface of second sheet material 26b opposite from second gap filler 24b is anti-adhesive surface 28 having lower adhesiveness than the second gap filler. In thermoelectric device 43, thermoelectric conversion unit 53 includes thermoelectric converter 12, first gap filler 24a, first sheet material 26a, second gap filler 24b, and second sheet material 26b.

In thermoelectric device 43 and thermoelectric conversion unit 53, anti-adhesive surface 28 of first sheet material 26a is in contact with first heat conductor 13. One surface of first gap filler 24a is in contact with a surface of first sheet material 26a opposite from anti-adhesive surface 28, whereas the other surface of first gap filler 24a is in contact with thermoelectric converter 12. Anti-adhesive surface 28 of second sheet material 26b is in contact with second heat conductor 14. One surface of second gap filler 24b is in contact with a surface of second sheet material 26b opposite from anti-adhesive surface 28, whereas the other surface of second gap filler 24b is in contact with thermoelectric converter 12.

As described above, thermoelectric device 43 includes thermoelectric converter 12, first and second heat conductors 13 and 14, first gap filler 24a, and first sheet material 26a. Thermoelectric converter 12 has thermoelectric elements 17 built-in. First and second heat conductors 13 and 14 face each other through thermoelectric converter 12. First gap filler 24a is disposed between thermoelectric converter 12 and first heat conductor 13. First sheet material 26a disposed between first heat conductor 13 and first gap filler 24a has flexibility. A surface of first sheet material 26a opposite from first gap filler 24a is anti-adhesive surface 28 having lower adhesiveness than first gap filler 24a.

Thermoelectric conversion unit 53 disposed between first and second heat conductors 13 and 14 includes thermoelectric converter 12, first gap filler 24a, and first sheet material 26a. Thermoelectric converter 12 has thermoelectric elements 17 built-in. First gap filler 24a is disposed between thermoelectric converter 12 and first heat conductor 13. First sheet material 26a disposed between first heat conductor 13 and first gap filler 24a has flexibility. A surface of first sheet material 26a opposite from first gap filler 24a is anti-adhesive surface 28 having lower adhesiveness than first gap filler 24a.

In like manner with description on thermoelectric device 41, thermoelectric device 43 and thermoelectric conversion unit 53 having the configuration described above can reduce loss of heat transmission between thermoelectric converter 12 and first heat conductor 13. Thermoelectric device 43 and thermoelectric conversion unit 53 prevent damage to internal thermoelectric elements 17 at the time of being disassembled into thermoelectric converter 12 and first heat conductor 13.

In thermoelectric device 43 and thermoelectric conversion unit 53, anti-adhesive surface 28 of first sheet material 26a is in contact with first heat conductor 13. This inhibits adhesion of first gap filler 24a to first heat conductor 13. As a result, thermoelectric converter 12 can be readily and efficiently repaired or replaced. This configuration reduces the occurrence of a stain on first heat conductor 13 owing to the adhesion of first gap filler 24a.

In thermoelectric device 43 and thermoelectric conversion unit 53, anti-adhesive surface 28 of second sheet material 26b is in contact with second heat conductor 14. This inhibits adhesion of second gap filler 24b to second heat conductor 14. As a result, thermoelectric converter 12 can be readily and efficiently repaired or replaced. This configuration reduces the occurrence of a stain on second heat conductor 14 owing to the adhesion of second gap filler 24b.

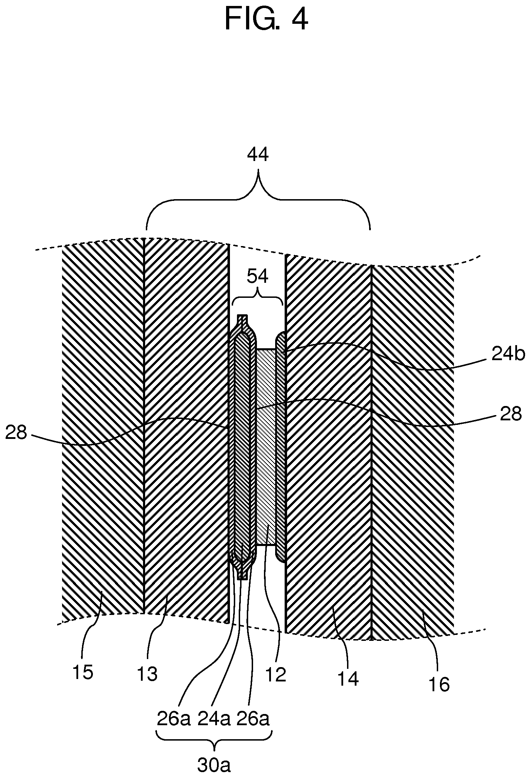

FIG. 4 is a cross-sectional view of thermoelectric device 44 according to another variation of the first exemplary embodiment of the present invention. Thermoelectric device 44 shown in FIG. 4 is equivalent to thermoelectric device 41 of FIG. 1 that further includes first sheet material 26a disposed between first heat conductor 13 and first gap filler 24a. In other words, first sheet materials 26a are disposed between first heat conductor 13 and first gap filler 24a and between thermoelectric converter 12 and first gap filler 24a, respectively. In thermoelectric device 44, first gap filler 24a and first sheet materials 26a constitute first sheet material unit 30a. In first sheet material unit 30a, both surfaces of first gap filler 24a are put between respective first sheet materials 26a, and a periphery of first gap filler 24a is hermetically sealed by first sheet materials 26a. In other words, an outer surface of first sheet material unit 30a is made up of anti-adhesive surfaces 28 of first sheet materials 26a. Anti-adhesive surfaces 28 of first sheet materials 26a are in contact with first heat conductor 13 and thermoelectric converter 12, respectively. In first sheet material unit 30a, first gap filler 24a may be put inside one first sheet material 26a and may be put between a plurality of first sheet materials 26a shown in FIG.4. In thermoelectric device 44, thermoelectric conversion unit 54 includes thermoelectric converter 12, first sheet material unit 30a, and second gap filler 24b.

As described above, in thermoelectric device 44, first sheet materials 26a are disposed between first heat conductor 13 and first gap filler 24a and between thermoelectric converter 12 and first gap filler 24a, respectively. Anti-adhesive surfaces 28 of first sheet materials 26a are in contact with first heat conductor 13 and thermoelectric converter 12, respectively.

This configuration ensures that both first heat conductor 13 and thermoelectric converter 12 are not in contact with first gap filler 24a in thermoelectric device 44. As a result, first gap filler 24a scarcely adheres to both first heat conductor 13 and thermoelectric converter 12, and first heat conductor 13 and thermoelectric converter 12 scarcely get sticky. This contributes to improved workability in disassembling thermoelectric device 44.

Since first gap filler 24a is hermetically sealed by first sheet materials 26a, thermoelectric device 44 inhibits the evaporation, oxidation, and deterioration of constituents of first gap filler 24a. This configuration enables the long-term use of first gap filler 24a and first sheet materials 26a putting first gap filler 24a therebetween and makes thermoelectric device 44 cost-effective.

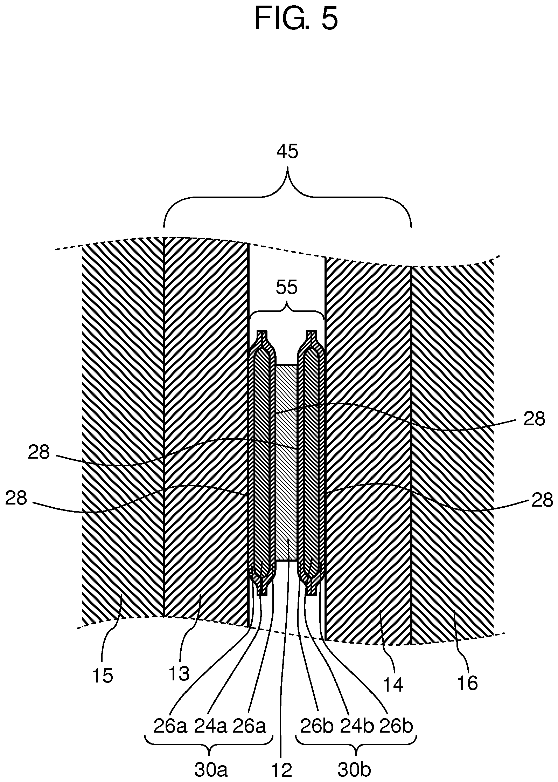

FIG. 5 is a cross-sectional view of thermoelectric device 45 according to another variation of the first exemplary embodiment of the present invention. Thermoelectric device 45 is equivalent to thermoelectric device 44 of FIG. 4 that includes second sheet material unit 30b in place of second gap filler 24b. In second sheet material unit 30b as with first sheet material unit 30a, both surfaces of second gap filler 24b are put between respective second sheet materials 26b, and a periphery of second gap filler 24b is hermetically sealed by second sheet materials 26b. In other words, an outer surface of second sheet material unit 30b is made up of anti-adhesive surfaces 28 of second sheet materials 26b. In thermoelectric device 45, thermoelectric conversion unit 55 includes thermoelectric converter 12, and first and second sheet material units 30a and 30b.

Thus, in thermoelectric device 45, second sheet materials 26b are disposed between second heat conductor 14 and second gap filler 24b and between thermoelectric converter 12 and second gap filler 24b, respectively. Anti-adhesive surfaces 28 of second sheet materials 26b are in contact with second heat conductor 14 and thermoelectric converter 12, respectively.

This configuration ensures that both second heat conductor 14 and thermoelectric converter 12 are not in contact with second gap filler 24b in thermoelectric device 45. As a result, second gap filler 24b scarcely adheres to both second heat conductor 14 and thermoelectric converter 12, and second heat conductor 14 and thermoelectric converter 12 scarcely get sticky. This contributes to improved workability in disassembling thermoelectric device 45.

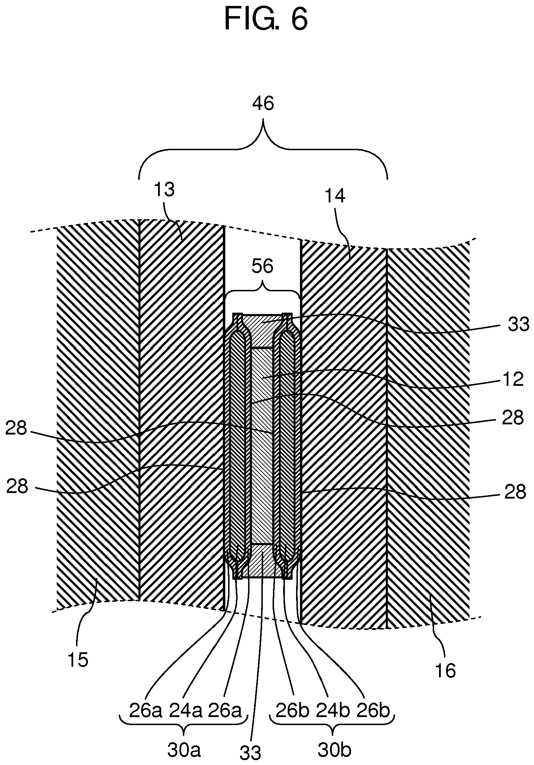

FIG. 6 is a cross-sectional view of thermoelectric device 46 according to another variation of the first exemplary embodiment of the present invention. Thermoelectric device 46 is equivalent to thermoelectric device 45 of FIG. 5 that further includes thermal insulation 33. Thermal insulation 33 includes a resin having low thermal conductivity, for example. Thermal insulation 33 is disposed in a space between anti-adhesive surfaces 28 of first sheet materials 26a and anti-adhesive surfaces 28 of second sheet materials 26b, wherein the space is not occupied by thermoelectric converter 12. In thermoelectric device 46, thermoelectric conversion unit 56 includes thermoelectric converter 12, first and second sheet material units 30a and 30b, and thermal insulation 33.

Thermoelectric device 46 shown in FIG. 6 includes additional thermal insulation 33. First sheet materials 26a are disposed between first heat conductor 13 and first gap filler 24a and between thermoelectric converter 12 and first gap filler 24a, respectively. Anti-adhesive surfaces 28 of first sheet materials 26a are in contact with first heat conductor 13 and thermoelectric converter 12, respectively. Second sheet materials 26b are disposed between second heat conductor 14 and second gap filler 24b and between thermoelectric converter 12 and second gap filler 24b, respectively. Anti-adhesive surfaces 28 of second sheet materials 26b are in contact with second heat conductor 14 and thermoelectric converter 12, respectively. Thermal insulation 33 is disposed in a space between anti-adhesive surfaces 28 of first sheet materials 26a and anti-adhesive surfaces 28 of second sheet materials 26b, wherein the space is not occupied by thermoelectric converter 12.

This configuration enables thermoelectric device 46 to inhibit heat from flowing between first and second heat conductors 13 and 14 without passing through thermoelectric converter 12. As a result, thermoelectric converter 12 provides improved efficiency in power generation or heat exchange. Since thermal insulation 33 prevents direct contact between first and second sheet materials 26a and 26b, the thermoelectric device reduces power generation or heat exchange losses.

Thermoelectric devices 41 to 46 or thermoelectric conversion units 51 to 56 described above may be in accordance with other variations shown below or combinations of some of the variations.
(1) Thermoelectric device 41 and thermoelectric conversion unit 51 in FIG. 1 may have no second gap filler 24b. Thermoelectric device 41 and thermoelectric conversion unit 51 even without second gap filler 24b have the effect of preventing damage to internal thermoelectric elements 17 at the time of disassembling work.
(2) In thermoelectric device 41 and thermoelectric conversion unit 51 in FIG. 1, anti-adhesive surface 28 of first sheet material 26a may not be in contact with thermoelectric converter 12. For example, another sheet may be interposed between anti-adhesive surface 28 and thermoelectric converter 12. In thermoelectric device 41 and thermoelectric conversion unit 51, the surface of first sheet material 26a opposite from anti-adhesive surface 28 may not be in contact with first gap filler 24a. For example, another sheet may be interposed between the surface of the first sheet material 26a opposite from anti-adhesive surface 28 and first gap filler 24a.
(3) In thermoelectric device 42 and thermoelectric conversion unit 52 in FIG. 2, anti-adhesive surface 28 of second sheet material 26b may not be in contact with thermoelectric converter 12. In thermoelectric device 41 and thermoelectric conversion unit 51, the surface of second sheet material 26b opposite from anti-adhesive surface 28 may not be in contact with second gap filler 24b.
(4) In thermoelectric device 43 and thermoelectric conversion unit 53 in FIG. 3, anti-adhesive surface 28 of first sheet material 26a may not be in contact with first heat conductor 13. In thermoelectric device 43 and thermoelectric conversion unit 53, anti-adhesive surface 28 of second sheet material 26b may not be in contact with second heat conductor 14.
(5) In thermoelectric device 41 and thermoelectric conversion unit 51 in FIG. 1, first gap filler 24a may not be hermetically sealed by first sheet material 26a.
(6) In thermoelectric device 43 and thermoelectric conversion unit 53 in FIG. 3, first gap filler 24a may be hermetically sealed by first sheet material 26a. In other words, the surface of first sheet material 26a opposite from anti-adhesive surface 28 may be contiguous to first gap filler 24a such that thermoelectric converter 12 and first sheet material 26a hermetically seal first gap filler 24a.

### SECOND EXEMPLARY EMBODIMENT

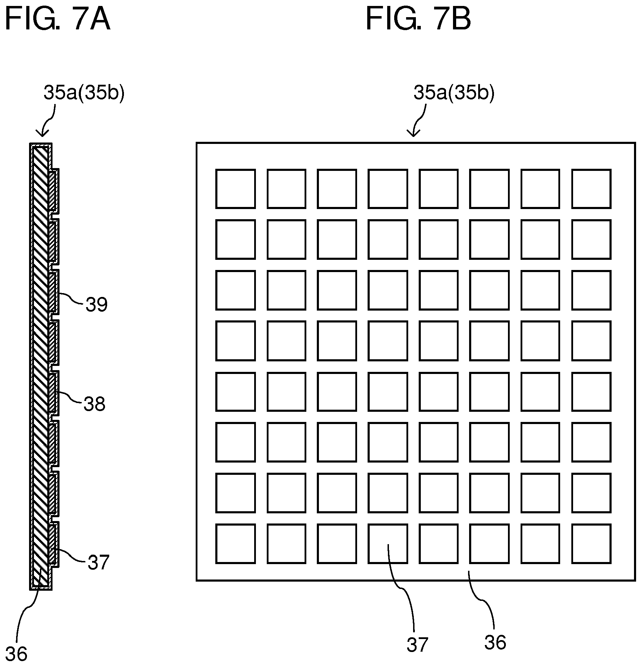

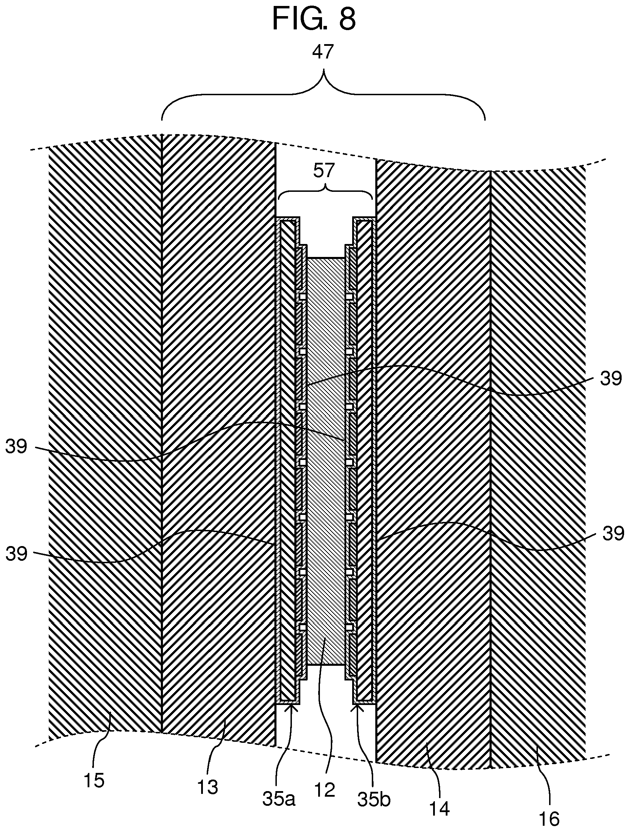

FIG. 7A is a cross-sectional view illustrating first sheet material unit 35a or second sheet material unit 35b, i.e., a component of thermoelectric device 47 (refer to FIG. 8) according to a second exemplary embodiment of the present invention. FIG. 7B is an elevation view of first sheet material unit 35a or second sheet material unit 35b.

With reference to FIGS. 7A and 7B, first sheet material unit 35a includes core sheet 36, resin film 37 equivalent to a first gap filler, and metal film 38 equivalent to a first sheet material. Second sheet material unit 35b, in like manner with first sheet material unit 35a, includes core sheet 36, resin film 37 equivalent to a second gap filler, and metal film 38 equivalent to a second sheet material.

Core sheet 36 is aluminum foil, copper foil, or other metallic foil, for example. Resin film 37 is made from a sheet-shaped silicone resin, for example, and may contain dispersed granules of a metal, a metallic oxide or a similar substance that possess satisfactory thermal conductivity. Resin film 37 can be formed by bonding a sheet-shaped resin to one surface of core sheet 36, or by printing a desired pattern of a fluid resin on the surface of the core sheet and thermally or optically polymerizing the components, for example. Metal film 38 is made from aluminum, copper, or other metal, for example. Metal film 38 can be formed on the surface of core sheet 36 on which resin film 37 is formed, by vapor deposition, electroless plating, electrolytic plating, or a combination of some of these methods, for example.

In first and second sheet material units 35a and 35b, resin film 37 functions as a gap filler having pliability, whereas metal film 38 functions as a sheet material having flexibility. A surface of metal film 38 opposite from resin film 37 is anti-adhesive surface 39 having lower adhesiveness than resin film 37.

FIG. 8 is a cross-sectional view of thermoelectric device 47 according to the second exemplary embodiment of the present invention. Thermoelectric device 47 includes thermoelectric converter 12, first heat conductor 13, second heat conductor 14, first sheet material unit 35a, and second sheet material unit 35b. First sheet material unit 35a is disposed between thermoelectric converter 12 and first heat conductor 13, whereas second sheet material unit 35b is disposed between thermoelectric converter 12 and second heat conductor 14. First and second sheet material units 35a and 35b each have resin film 37 equivalent to a gap filler and can thus be transformed to adapt to the shapes of microscopic asperities on surfaces of thermoelectric converter 12 and first heat conductor 13 or second heat conductor 14. This configuration reduces loss of heat transmission between first and second heat conductors 13 and 14. First and second sheet material units 35a and 35b each have metal film 38 equivalent to a sheet material having flexibility. Anti-adhesive surfaces 39, i.e., surfaces of metal films 38, are in contact with thermoelectric converter 12 and first and second heat conductors 13 and 14. This configuration holds down adsorption between thermoelectric converter 12 and either of first heat conductor 13 and second heat conductor 14. Accordingly, thermoelectric device 47 can reduce stress applied to thermoelectric converter 12 at the time of disassembling of thermoelectric device 47 and thereby prevent damage to internal thermoelectric elements 17.

First and second sheet material units 35a and 35b reduce adsorption between thermoelectric converter 12 and each of first and second heat conductors 13 and 14. This configuration facilitates disassembling of thermoelectric device 47 and improves efficiency in replacement or repair of thermoelectric converter 12.

As described above, thermoelectric device 47 includes thermoelectric converter 12, first and second heat conductors 13 and 14, first gap filler (resin film 37), and first sheet material (metal film 38). Thermoelectric converter 12 has thermoelectric elements 17 built-in. First and second heat conductors 13 and 14 face each other through thermoelectric converter 12. First gap filler (resin film 37) is disposed between thermoelectric converter 12 and first heat conductor 13. First sheet material (metal film 38) has flexibility and is disposed between first heat conductor 13 and first gap filler (resin film 37) and/or between thermoelectric converter 12 and first gap filler (resin film 37). The surface of first sheet material (metal film 38) opposite from first gap filler (resin film 37) is anti-adhesive surface 39 having lower adhesiveness than first gap filler (resin film 37).

Owing to this configuration, thermoelectric device 47 can reduce loss of heat transmission between thermoelectric converter 12 and first heat conductor 13. At the same time, thermoelectric device 47 prevents damage to internal thermoelectric elements 17 at the time of being disassembled into thermoelectric converter 12 and first heat conductor 13.

Thermoelectric device 47 further includes second gap filler (resin film 37) and second sheet material (metal film 38). Second gap filler (resin film 37) is disposed between thermoelectric converter 12 and second heat conductor 14. Second sheet material (metal film 38) has flexibility and is disposed between second heat conductor 14 and second gap filler (resin film 37) and/or between thermoelectric converter 12 and second gap filler (resin film 37). The surface of second sheet material (metal film 38) opposite from second gap filler (resin film 37) is anti-adhesive surface 39 having lower adhesiveness than second gap filler (resin film 37).

Owing to this configuration, thermoelectric device 47 can reduce loss of heat transmission between thermoelectric converter 12 and second heat conductor 14. At the same time, thermoelectric device 47 prevents damage to internal thermoelectric elements 17 at the time of being disassembled into thermoelectric converter 12 and second heat conductor 14.

As shown in FIG. 8, thermoelectric conversion unit 57 in the second exemplary embodiment includes thermoelectric converter 12 and a pair of first and second sheet material units 35a, 35b that put thermoelectric converter 12 therebetween.

Thermoelectric conversion unit 57 is disposed between first and second heat conductors 13 and 14. Thermoelectric conversion unit 57 includes thermoelectric converter 12, first gap filler (resin film 37), and first sheet material (metal film 38). Thermoelectric converter 12 has thermoelectric elements 17 built-in. First gap filler (resin film 37) is disposed between thermoelectric converter 12 and the first heat conductor. First sheet material (metal film 38) has flexibility and is disposed between first heat conductor 13 and first gap filler (resin film 37) and/or between thermoelectric converter 12 and first gap filler (resin film 37). The surface of first sheet material (metal film 38) opposite from first gap filler (resin film 37) is anti-adhesive surface 39 having lower adhesiveness than first gap filler (resin film 37).

This configuration allows thermoelectric conversion unit 57 to reduce loss of heat transmission between thermoelectric converter 12 and first heat conductor 13. This configuration also reduces stress applied to thermoelectric converter 12 at the time of disassembling thermoelectric device 47 into thermoelectric converter 12 and first heat conductor 13. Thus, thermoelectric conversion unit 57 prevents damage to internal thermoelectric elements 17.

Thermoelectric conversion unit 57 further includes second gap filler (resin film 37) and second sheet material (metal film 38). Second gap filler (resin film 37) is disposed between thermoelectric converter 12 and second heat conductor 14. Second sheet material (metal film 38) has flexibility and is disposed between second heat conductor 14 and second gap filler (resin film 37) and/or between thermoelectric converter 12 and second gap filler (resin film 37). The surface of second sheet material (metal film 38) opposite from second gap filler (resin film 37) is an anti-adhesive surface having lower adhesiveness than second gap filler (resin film 37).

This configuration allows thermoelectric conversion unit 57 to reduce loss of heat transmission between thermoelectric converter 12 and second heat conductor 14. This configuration also reduces stress applied to thermoelectric converter 12 at the time of disassembling thermoelectric device 47 into thermoelectric converter 12 and second heat conductor 14. Thus, thermoelectric conversion unit 57 prevents damage to internal thermoelectric elements 17. Thermoelectric conversion unit 57 has first and second sheet material units 35a and 35b at respective sides of thermoelectric converter 12. However, thermoelectric conversion unit 57 may have first sheet material unit 35a or second sheet material unit 35b at only one side of the thermoelectric converter. Even this configuration enables thermoelectric conversion unit 57 to have the effect of preventing damage to internal thermoelectric elements 17.

### INDUSTRIAL APPLICABILITY

A thermoelectric device and a thermoelectric conversion unit according to the present invention are useful as an electric power generator utilizing temperature difference or a heat exchanger having a thermoelectric element.

### REFERENCE MARKS IN THE DRAWINGS

- 12:: thermoelectric converter
- 13:: first heat conductor
- 14:: second heat conductor
- 15:: first medium
- 16:: second medium
- 17:: thermoelectric element
- 18:: substrate
- 19:: electrode
- 20:: lead
- 21:: sealant
- 24a:: first gap filler
- 24b:: second gap filler
- 26a:: first sheet material
- 26b:: second sheet material
- 28, 39:: anti-adhesive surface
- 30a, 35a:: first sheet material unit
- 30b, 35b:: second sheet material unit
- 33:: thermal insulation
- 36:: core sheet
- 37:: resin film
- 38:: metal film
- 41, 42, 43, 44, 45, 46, 47:: thermoelectric device
- 51, 52, 53, 54, 55, 56, 57:: thermoelectric conversion unit

## Claims

1. A thermoelectric device comprising:
a thermoelectric converter (12) having a thermoelectric element (17) built-in;
a first heat conductor (13) and a second heat conductor (14) facing each other through the thermoelectric converter (12) ;
a first gap filler (24a) disposed between the thermoelectric converter (12) and the first heat conductor (13); and
a first sheet material (26a) disposed between the first heat conductor (13) and the first gap filler (24a) and/or between the thermoelectric converter (12) and the first gap filler (24a), the first sheet material (26a) having flexibility,
wherein a surface (28) of the first sheet material (26a) opposite from the first gap filler (24a) is an anti-adhesive surface having lower adhesiveness than the first gap filler (24a),
the thermoelectric converter (12) has a plurality of the thermoelectric elements (17) between a pair of substrates (18), and
the first gap filler (24a) is formed of thermal conductive grease.

2. The thermoelectric device according to claim 1, wherein the first sheet material (26a) is metallic foil.

3. The thermoelectric device according to claim 1, wherein the thermoelectric converter (12) and the first heat conductor (13) are separable from each other.

4. The thermoelectric device according to claim 1, wherein the anti-adhesive surface (28) is in contact with the first heat conductor (13).

5. The thermoelectric device according to claim 1, wherein the anti-adhesive surface (28) is in contact with the thermoelectric converter (12).

6. The thermoelectric device according to claim 1, wherein
the first sheet material (26a) is disposed both between the first heat conductor (13) and the first gap filler (24a) and between the thermoelectric converter (12) and the first gap filler (24a), and
the anti-adhesive surface (28) of the first sheet material (26a) is in contact with both the first heat conductor (13) and the thermoelectric converter (12).

7. The thermoelectric device according to claim 1, wherein the first gap filler (24a) is hermetically sealed by the first sheet material (26a).

8. The thermoelectric device according to claim 1, further comprising:
a second gap filler (24b) disposed between the thermoelectric converter (12) and the second heat conductor (14); and
a second sheet material (26b) disposed between the second heat conductor (14) and the second gap filler (24b) and/or between the thermoelectric converter (12) and the second gap filler (24b), the second sheet material (26b) having flexibility,
wherein a surface (28) of the second sheet material (26b) opposite from the second gap filler (24b) is an anti-adhesive surface having lower adhesiveness than the second gap filler (24b), and
the second gap filler (24b) is formed of thermal conductive grease.

9. The thermoelectric device according to claim 8, wherein
the first sheet material (26a) is disposed both between the first heat conductor (13) and the first gap filler (24a) and between the thermoelectric converter (12) and the first gap filler (24a), and the anti-adhesive surface (28) of the first sheet material (26a) is in contact with both the first heat conductor (13) and the thermoelectric converter (12),
the second sheet material (26b) is disposed both between the second heat conductor (14) and the second gap filler (24b) and between the thermoelectric converter (12) and the second gap filler (24b), and the anti-adhesive surface (28) of the second sheet material (26b) is in contact with both the second heat conductor (14) and the thermoelectric converter (12), and
thermal insulation (33) is disposed in a space between the anti-adhesive surface (28) of the first sheet material (26a) and the anti-adhesive surface (28) of the second sheet material (26b), the space being not occupied by the thermoelectric converter (12).

10. The thermoelectric device according to claim 1, acting as an electric power generator by making use of a temperature difference between the first and the second heat conductors (13, 14).

11. The thermoelectric device according to claim 1, acting as a heat exchanger that promotes or reduces heat transmission from one of the first and the second heat conductors (13, 14) to the other heat conductor by letting electric power supplied to the thermoelectric converter (12).

12. A thermoelectric conversion unit for the thermoelectric device of claim 1, for being disposed between a first heat conductor (13) and a second heat conductor (14), the thermoelectric conversion unit comprising:
a thermoelectric converter (12) having a thermoelectric element (17) built-in;
a first gap filler (24a) arranged to be disposed between the thermoelectric converter (12) and the first heat conductor (13); and
a first sheet material (26a) arranged to be disposed between the first heat conductor (13) and the first gap filler (24a) and/or between the thermoelectric converter (12) and the first gap filler (24a), the first sheet material (26a) having flexibility,
wherein a surface (28) of the first sheet material (26a) opposite from the first gap filler (24a) is an anti-adhesive surface having lower adhesiveness than the first gap filler,
the thermoelectric converter (12) has a plurality of the thermoelectric elements (17) between a pair of substrates (18), and
the first gap filler (24a) is formed of thermal conductive grease.

13. The thermoelectric conversion unit according to claim 12, further comprising:
a second gap filler (24b) arranged to be disposed between the thermoelectric converter (12) and the second heat conductor (14); and
a second sheet material (26b) arranged to be disposed between the second heat conductor (14) and the second gap filler (24b) and/or between the thermoelectric converter (12) and the second gap filler (24b), the second sheet material (26b) having flexibility,
wherein a surface (28) of the second sheet material (26b) opposite from the second gap filler (24b) is an anti-adhesive surface having lower adhesiveness than the second gap filler (24b), and
the second gap filler (24b) is formed of thermal conductive grease.

## Patentansprüche

1. Thermoelektrische Vorrichtung, umfassend:
einen thermoelektrischen Wandler (12) mit einem eingebauten thermoelektrischen Element (17);
einen ersten Wärmeleiter (13) und einen zweiten Wärmeleiter (14), die durch den thermoelektrischen Wandler (12) einander zugewandt sind;
einen ersten Lückenfüller (24a), der zwischen dem thermoelektrischen Wandler (12) und dem ersten Wärmeleiter (13) angeordnet ist; und
ein erstes Bogenmaterial (26a), das zwischen dem ersten Wärmeleiter (13) und dem ersten Lückenfüller (24a) und/oder zwischen dem thermoelektrischen Wandler (12) und dem ersten Lückenfüllstoff (24a) angeordnet ist, wobei das erste Bogenmaterial (26a) flexibel ist,
wobei eine dem ersten Lückenfüller (24a) entgegengesetzte Fläche (28) des ersten Bogenmaterials (26a) eine Antihaftfläche mit geringerem Haftvermögen als der erste Lückenfüller (24a) ist,
der thermoelektrische Wandler (12) eine Mehrzahl von thermoelektrischen Elementen (17) zwischen einem Paar von Substraten (18) aufweist, und
der erste Lückenfüller (24a) aus wärmeleitfähigem Fett gebildet ist.

2. Thermoelektrische Vorrichtung nach Anspruch 1, wobei das erste Bogenmaterial (26a) eine metallische Folie ist.

3. Thermoelektrische Vorrichtung nach Anspruch 1, wobei der thermoelektrische Wandler (12) und der erste Wärmeleiter (13) voneinander trennbar sind.

4. Thermoelektrische Vorrichtung nach Anspruch 1, wobei die Antihaftfläche (28) mit dem ersten Wärmeleiter (13) in Kontakt steht.

5. Thermoelektrische Vorrichtung nach Anspruch 1, wobei die Antihaftfläche (28) mit dem thermoelektrischen Wandler (12) in Kontakt steht.

6. Thermoelektrische Vorrichtung nach Anspruch 1, wobei das erste Bogenmaterial (26a) sowohl zwischen dem ersten Wärmeleiter (13) und dem ersten Lückenfüller (24a) als auch zwischen dem thermoelektrischen Wandler (12) und dem ersten Lückenfüller (24a) angeordnet ist, und
die Antihaftfläche (28) des ersten Bogenmaterials (26a) sowohl mit dem ersten Wärmeleiter (13) als auch mit dem thermoelektrischen Wandler (12) in Kontakt steht.

7. Thermoelektrische Vorrichtung nach Anspruch 1, wobei der erste Lückenfüller (24a) durch das erste Bogenmaterial (26a) hermetisch verschlossen ist.

8. Thermoelektrische Vorrichtung nach Anspruch 1, ferner umfassend:
einen zweiten Lückenfüller (24b), der zwischen dem thermoelektrischen Wandler (12) und dem zweiten Wärmeleiter (14) angeordnet ist; und
ein zweites Bogenmaterial (26b), das zwischen dem zweiten Wärmeleiter (14) und dem zweiten Lückenfüller (24b) und/oder zwischen dem thermoelektrischen Wandler (12) und dem zweiten Lückenfüller (24b) angeordnet ist, wobei das zweite Bogenmaterial (26b) flexibel ist,
wobei eine dem zweiten Lückenfüller (24b) entgegengesetzte Fläche (28) des zweiten Bogenmaterials (26b) eine Antihaftfläche mit geringerem Haftvermögen als der zweite Lückenfüller (24b) ist, und der zweite Lückenfüller (24b) aus wärmeleitfähigem Fett gebildet ist.

9. Thermoelektrische Vorrichtung nach Anspruch 8, wobei
das erste Bogenmaterial (26a) sowohl zwischen dem ersten Wärmeleiter (13) und dem ersten Lückenfüller (24a) als auch zwischen dem thermoelektrischen Wandler (12) und dem ersten Lückenfüller (24a) angeordnet ist und die Antihaftfläche (28) des ersten Bogenmaterials (26a) sowohl mit dem ersten Wärmeleiter (13) als auch mit dem thermoelektrischen Wandler (12) in Kontakt steht,
das zweite Bogenmaterial (26b) sowohl zwischen dem zweiten Wärmeleiter (14) und dem zweiten Lückenfüller (24b) als auch zwischen dem thermoelektrischen Wandler (12) und dem zweiten Lückenfüller (24b) angeordnet ist und die Antihaftfläche (28) des zweiten Bogenmaterials (26b) sowohl mit dem zweiten Wärmeleiter (14) als auch mit dem thermoelektrischen Wandler (12) in Kontakt steht, und
die Wärmedämmung (33) in einem Raum zwischen der Antihaftfläche (28) des ersten Bogenmaterials (26a) und der Antihaftfläche (28) des zweiten Bogenmaterials (26b) angeordnet ist, wobei der Raum nicht durch den thermoelektrischen Wandler (12) belegt ist.

10. Thermoelektrische Vorrichtung nach Anspruch 1, die als Stromgenerator wirkt, indem sie eine Temperaturdifferenz zwischen dem ersten und dem zweiten Wärmeleiter (13, 14) nutzt.

11. Thermoelektrische Vorrichtung nach Anspruch 1, die als Wärmetauscher wirkt, der die Wärmeübertragung von einem des ersten und zweiten Wärmeleiters (13, 14) zum anderen Wärmeleiter fördert oder reduziert, indem dem thermoelektrischen Wandler (12) elektrische Energie zugeführt wird.

12. Thermoelektrische Umwandlungseinheit für die thermoelektrische Vorrichtung nach Anspruch 1, die zwischen einem ersten Wärmeleiter (13) und einem zweiten Wärmeleiter (14) angeordnet werden soll, wobei die thermoelektrische Umwandlungseinheit Folgendes umfasst:
einen thermoelektrischen Wandler (12) mit einem eingebauten thermoelektrischen Element (17);
einen ersten Lückenfüller (24a), der zwischen dem thermoelektrischen Wandler (12) und dem ersten Wärmeleiter (13) angeordnet werden soll; und
ein erstes Bogenmaterial (26a), das zwischen dem ersten Wärmeleiter (13) und dem ersten Lückenfüller (24a) und/oder zwischen dem thermoelektrischen Wandler (12) und dem ersten Lückenfüller (24a) angeordnet werden soll, wobei das erste Bogenmaterial (26a) flexibel ist,
wobei eine zum ersten Lückenfüller (24a) entgegengesetzte Oberfläche (28) des ersten Bogenmaterials (26a) eine Antihaftfläche mit geringerem Haftvermögen als der erste Lückenfüller ist,
der thermoelektrische Wandler (12) eine Mehrzahl von thermoelektrischen Elementen (17) zwischen einem Paar von Substraten (18) aufweist, und
der erste Lückenfüller (24a) aus wärmeleitfähigem Fett gebildet ist.

13. Thermoelektrische Umwandlungseinheit nach Anspruch 12, ferner umfassend:
einen zweiten Lückenfüller (24b), der zwischen dem thermoelektrischen Wandler (12) und dem zweiten Wärmeleiter (14) angeordnet werden soll; und
ein zweites Bogenmaterial (26b), das zwischen dem zweiten Wärmeleiter (14) und dem zweiten Lückenfüller (24b) und/oder zwischen dem thermoelektrischen Wandler (12) und dem zweiten Lückenfüller (24b) angeordnet werden soll, wobei das zweite Bogenmaterial (26b) flexibel ist,
wobei eine dem zweiten Lückenfüller (24b) entgegengesetzte Fläche (28) des zweiten Bogenmaterials (26b) eine Antihaftfläche mit geringerem Haftvermögen als der zweite Lückenfüller (24b) ist, und
der zweite Lückenfüller (24b) aus wärmeleitfähigem Fett gebildet ist.

## Revendications

1. Dispositif thermoélectrique qui comprend :
un convertisseur thermoélectrique (12) qui possède un élément thermoélectrique (17) intégré ;
un premier conducteur de chaleur (13) et un second conducteur de chaleur (14) qui se font face par le biais du convertisseur thermoélectrique (12) ;
un premier réémetteur de complément (24a) disposé entre le convertisseur thermoélectrique (12) et le premier conducteur de chaleur (13) ; et
une première feuille de matériau (26a) disposée entre le premier conducteur de chaleur (13) et le premier réémetteur de complément (24a) et/ou entre le convertisseur thermoélectrique (12) et le premier réémetteur de complément (24a), dans lequel la première feuille de matériau (26a) présente une flexibilité,
dans lequel une surface (28) de la première feuille de matériau (26a) opposée au premier réémetteur de complément (24a) est une surface antiadhésive qui présente une plus faible adhésivité que le premier réémetteur de complément (24a),
le convertisseur thermoélectrique (12) possède une pluralité d'éléments thermoélectriques (17) entre une paire de substrats (18), et
le premier réémetteur de complément (24a) est formé d'une graisse conductrice thermique.

2. Dispositif thermoélectrique selon la revendication 1, dans lequel la première feuille de matériau (26a) est une feuille métallique.

3. Dispositif thermoélectrique selon la revendication 1, dans lequel le convertisseur thermoélectrique (12) et le premier conducteur de chaleur (13) peuvent être séparés l'un de l'autre.

4. Dispositif thermoélectrique selon la revendication 1, dans lequel la surface antiadhésive (28) est en contact avec le premier conducteur de chaleur (13).

5. Dispositif thermoélectrique selon la revendication 1, dans lequel la surface antiadhésive (28) est en contact avec le convertisseur thermoélectrique (12).

6. Dispositif thermoélectrique selon la revendication 1, dans lequel
la première feuille de matériau (26a) est disposée entre le premier conducteur de chaleur (13) et le premier réémetteur de complément (24a) et entre le convertisseur thermoélectrique (12) et le premier réémetteur de complément (24a), et
la surface antiadhésive (28) de la première feuille de matériau (26a) est en contact avec le premier conducteur de chaleur (13) et le convertisseur thermoélectrique (12).

7. Dispositif thermoélectrique selon la revendication 1, dans lequel le premier réémetteur de complément (24a) est fermé hermétiquement par la première feuille de matériau (26a).

8. Dispositif thermoélectrique selon la revendication 1, qui comprend en outre :
un second réémetteur de complément (24b) disposé entre le convertisseur thermoélectrique (12) et le second conducteur de chaleur (14) ; et
une seconde feuille de matériau (26b) disposée entre le second conducteur de chaleur (14) et le second réémetteur de complément (24b) et/ou entre le convertisseur thermoélectrique (12) et le second réémetteur de complément (24b), dans lequel la seconde feuille de matériau (26b) présente une flexibilité,
dans lequel une surface (28) de la seconde feuille de matériau (26b) opposée au second réémetteur de complément (24b) est une surface antiadhésive qui présente une plus faible adhésivité que le second réémetteur de complément (24b), et
le second réémetteur de complément (24b) est formé d'une graisse conductrice thermique.

9. Dispositif thermoélectrique selon la revendication 8, dans lequel
la première feuille de matériau (26a) est disposée entre le premier conducteur de chaleur (13) et le premier réémetteur de complément (24a) et entre le convertisseur thermoélectrique (12) et le premier réémetteur de complément (24a), et la surface antiadhésive (28) de la première feuille de matériau (26a) est en contact avec le premier conducteur de chaleur (13) et le convertisseur thermoélectrique (12),
la seconde feuille de matériau (26b) est disposée entre le second conducteur de chaleur (14) et le second réémetteur de complément (24b) et entre le convertisseur thermoélectrique (12) et le second réémetteur de complément (24b), et la surface antiadhésive (28) de la seconde feuille de matériau (26b) est en contact avec le second conducteur de chaleur (14) et le convertisseur thermoélectrique (12), et
une isolation thermique (33) est disposée dans un espace entre la surface antiadhésive (28) de la première feuille de matériau (26a) et la surface antiadhésive (28) de la seconde feuille de matériau (26b), dans lequel l'espace n'est pas occupé par le convertisseur thermoélectrique (12).

10. Dispositif thermoélectrique selon la revendication 1, qui agit comme un générateur d'électricité en utilisant une différence de température entre le premier et le second conducteurs de chaleur (13, 14).

11. Dispositif thermoélectrique selon la revendication 1, qui agit comme un échangeur thermique qui favorise ou réduit la transmission de chaleur depuis l'un du premier et du second conducteurs de chaleur (13, 14) vers l'autre conducteur de chaleur en laissant l'électricité être fournie au convertisseur thermoélectrique (12).

12. Unité de conversion thermoélectrique destinée au dispositif thermoélectrique de la revendication 1, afin d'être disposée entre un premier conducteur de chaleur (13) et un second conducteur de chaleur (14), dans laquelle l'unité de conversion thermoélectrique comprend :
un convertisseur thermoélectrique (12) qui possède un élément thermoélectrique (17) intégré ;
un premier réémetteur de complément (24a) prévu pour être disposé entre le convertisseur thermoélectrique (12) et le premier conducteur de chaleur (13) ; et
une première feuille de matériau (26a) prévue pour être disposée entre le premier conducteur de chaleur (13) et le premier réémetteur de complément (24a) et/ou entre le convertisseur thermoélectrique (12) et le premier réémetteur de complément (24a), dans laquelle la première feuille de matériau (26a) présente une flexibilité,
dans laquelle une surface (28) de la première feuille de matériau (26a) opposée au premier réémetteur de complément (24a) est une surface antiadhésive qui présente une plus faible adhésivité que le premier réémetteur de complément,
le convertisseur thermoélectrique (12) possède une pluralité d'éléments thermoélectriques (17) entre une paire de substrats (18), et
le premier réémetteur de complément (24a) est formé d'une graisse conductrice thermique.

13. Unité de conversion thermoélectrique selon la revendication 12, qui comprend en outre :
un second réémetteur de complément (24b) prévu pour être disposé entre le convertisseur thermoélectrique (12) et le second conducteur de chaleur (14) ; et
une seconde feuille de matériau (26b) disposée entre le second conducteur de chaleur (14) et le second réémetteur de complément (24b) et/ou entre le convertisseur thermoélectrique (12) et le second réémetteur de complément (24b), dans laquelle la seconde feuille de matériau (26b) présente une flexibilité,
dans laquelle une surface (28) de la seconde feuille de matériau (26b) opposée au second réémetteur de complément (24b) est une surface antiadhésive qui présente une plus faible adhésivité que le second réémetteur de complément (24b), et
le second réémetteur de complément (24b) est formé d'une graisse conductrice thermique.
